# EUROPEAN PATENT APPLICATION

(11) **EP 2 361 002 A1**
(43) Date of publication of application: **24.08.2011**
(21) Application number: 11151514.4
(22) Date of filing: 20.01.2011
(51) Int. Cl.: H05K 5/02, G07C 5/08

(54) **Container, navigation data recording module, and navigation data recording apparatus**

(30) Priority: 21.01.2010 JP 2010012153
(71) Applicant: Furuno Electric Company Limited, Hyogo-pref (JP)
(72) Inventor: Ogawa, Yoshitaka, Nishinomiya City (JP)
(74) Representative: Arrowsmith, Peter Michael E.

(57) **Abstract**

This disclosure provides a container, which includes a containing part (45), a cooling part (44) arranged outside of the containing part and for cooling by a heat absorbing action at the time of a phase transition, and a heat insulating part (41) arranged outside of the cooling part. The container may further include a holding part (42) arranged outside of the cooling part and for holding the cooling part near the containing part (45). Another cooling part (37) may be arranged outside of the heat insulating part (41), in addition to the inside of the heat insulating part. The cooling part may be a bag shaped container filled with a cooling material and may have a joined part (44a) formed by closing an opening of the container. The joined part may be configured to be exfoliated when a temperature near the cooling part reaches a predetermined temperature or more.

## Description

### Cross-Reference to Related Application(s)

The application claims priority under 35 U.S.C. § 119 to Japanese Patent Application No. 2010-012153, which was filed on January 22, 2010, the entire disclosure of which is hereby incorporated by reference.

### Technical Field

The present invention relates to a container that can protect contents from heat.

### Background

Conventionally, containers which can protect contents having low heat resistance, such as paper sheets, films, and electronic instruments, from a fire are known. JP08-214932A discloses such kind of containers.

JP08-2149332A discloses a fire-resistant container provided with a primary container made of a wall material impregnated with nonflammable liquid, and a secondary container made of a heat insulating material. Between the primary container and the secondary container, a member having moisture resistance is arranged. By this configuration, the fire-resistant container has the fire resistance, the heat insulating properties, and the moisture resistance, and can effectively protect the contents from heat.

Further, for a container which requires heat insulating properties, a navigation data recording apparatus in addition to the one described above has been known. The navigation data recording apparatus records data relating to an operation of a ship at the time of normal operation, and protects the recorded data from the heat of a fire when a marine accident occurs. Further, because a semiconductor which records the data is sensitive to heat, another navigation data recording apparatus having a cooling function in addition to the heat insulating function is also proposed. JP3878025B discloses such kind of navigation data recording apparatus.

The navigation data recording apparatus disclosed in JP3878025B includes a protecting section where a solid state memory for storing navigation data is arranged, an accommodating section for accommodating a thermal mass which functions as a heat sink, and a passage which can connect the two sections. The passage does not normally connect the two sections and, thus, the thermal mass cannot flow into the accommodating section.

When a fire due to a marine accident occurs and a temperature then reaches a predetermined level, a heat vent plug provided to a fusible valve which blocks the passage starts melting to open the passage, and the two sections are connected. After that, by the thermal mass moving to the protecting section, the protecting section can be cooled.

However, in JP08-2149332A, the container is not provided with a cooling function, in order to sufficiently protect the contents from a high temperature, thicknesses of the primary and secondary containers need to be thick. However in this case, each internal capacity becomes smaller with respect to the outline dimensions.

Further, in JP3878025B, the recording device connects the two sections by changing the phase of the heat vent plug constructed so as to contain a soldering material. Further, when cooling the semiconductor such as a solid state memory, it is preferred to start the cooling at a comparatively low temperature (for example, 100°C). Therefore, in JP3878025B, although a low temperature soldering material is supposedly applied as the soldering material, the low temperature soldering takes time for the phase change in many cases and, thus, an adjustment of timing to start the cooling has been difficult.

### Summary

The present invention is made in view of the above situations, and provides a container that can start cooling at a fixed temperature without any variation.

According to an aspect of the invention, a container is provided, which includes a containing part, a cooling part arranged outside of the containing part and for cooling by a heat absorbing action at the time of a phase transition, and a heat insulating part arranged outside of the cooling part.

Thereby, when a temperature inside the heat insulating part is increased by a fire or the like, the phase transition occurs in the cooling part. Because the temperature when the phase transition occurs is uniquely determined according to the material of the cooling part, a pressure, and the like, the cooling can always be started at a fixed temperature without any variation. Therefore, the cooling of the containing part can be started at a desired timing to effectively protect contents accommodated in the containing part from heat.

The container may further include a holding part arranged outside of the cooling part and for holding the cooling part near the containing part.

Another cooling part may also be arranged outside of the heat insulating part, in addition to the inside of the heat insulating part.

The cooling part may be a bag shaped container filled with a cooling material and may have a joined part formed by closing an opening of the container.

The joined part may be configured to be exfoliated when a temperature near the cooling part reaches a predetermined value or more.

At least a part of the cooling part may be made of metal.

According to another aspect of the invention, a navigation data recording module is provided, which includes the container of any one of the other aspects of the invention and a storage device for storing navigation data. The storing device is contained in the containing part.

Since the data recording module includes the storing device that is sensitive to heat, it needs to suitably detect that an accident such as a fire has occurred so that the cooling can immediately be started. Therefore, by applying the configuration of this aspect of the invention, the effect in which the cooling can always be started at the fixed temperature without any variation can be exerted more effectively.

The containing part may include a body part having a containing space and a lid part for covering an opening of the body part. The lead wire for transmitting to the storage device the navigation data inputted from outside may be connected to the storage device through a penetrating hole formed in the lid part in the thickness direction, and the lead wire is sealed in the penetrating hole with glass.

The lead wire may include a plurality of lead wires. The storing device may be arranged near the lid part. The ends of the lead wires are connected to the storage device.

The navigation data recording module may further include a data converting device for converting the navigation data inputted from outside. The data converting device may be arranged outside of the heat insulating part.

According to another aspect of the invention, a navigation data recording apparatus is provided, which includes the navigation data recording module of any one of the other aspects of the invention and a navigation data collecting module for receiving navigation data from a ship instrument and transmitting it to the navigation data recording module.

Thereby, the navigation data recording apparatus that can firmly protect the navigation data can be provided.

### Brief Description of the Drawings

The present disclosure is illustrated by way of example and not by way of limitation in the figures of the accompanying drawings, in which the like reference numeral indicate like elements and in which:

Fig. 1 is a block diagram showing a configuration of a navigation data recording apparatus according to an embodiment of the present invention;

Fig. 2 is an external perspective view of a data recording module;

Fig. 3 is an front cross-sectional view schematically showing a configuration inside of the data recording module;

Fig. 4 is an external perspective view showing the shape of a holding capsule; [0033.5] Fig. 5 is an external perspective view showing internal cooling packs and an inner capsule;

Figs. 6A and 6B are perspective views showing the internal cooling pack of before and after a joined part is exfoliated;

Fig. 7 is a perspective view showing a top side configuration of a lid part of the inner capsule;

Fig. 8 is a perspective view showing a bottom side configuration of the lid part of the inner capsule; and

Fig. 9 is a cross-sectional view showing how a pair of lead wires is sealed in a penetrating hole with glass.

### Description of Embodiment

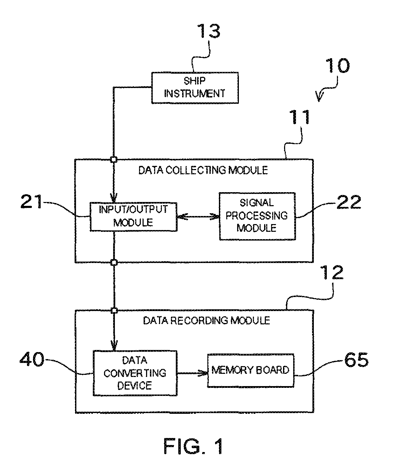

Next, an embodiment of the present invention is described with reference to the appended drawings. Fig. 1 is a block diagram showing a configuration of a navigation data recording apparatus 10 of this embodiment.

The navigation data recording apparatus 10 can record data relating to an operation of a ship that equips the apparatus 10 and various kinds of matters occur in the ship. If a marine accident occurs, the recorded data is analyzed to be used for determining the cause and preventing a reoccurrence of the accident.

As shown in Fig. 1, the navigation data recording apparatus 10 includes a data collecting module 11 (navigation data collecting module) and a data recording module 12 (container or navigation data recording module).

The data collecting module 11 is electrically connected to a ship instrument 13, and the ship instrument 13 inputs various data relating to navigation to the data collecting module 11. Particular examples of the ship instrument 13 for transmitting the data (navigation data) to the data collecting module 11 include a GPS device for measuring a position of the ship, and date and time, a speed sensor for measuring a speed of the ship, various compasses for measuring a bow azimuth direction, a vane anemometer for detecting a direction and speed of wind on the sea where the ship travels, a depth finder for measuring a water depth, a microphone for receiving sounds from the bridge, and a radar device for acquiring a radar image indicating situations around the ship.

The data collecting module 11 mainly includes an input/output module 21 for loading the navigation data, a signal processing module 22 for processing the loaded navigation data. This collected navigation data is transmitted from the input/output module 21 to a data converting device 40 of the data recording module 12.

The data converting device 40 converts the received navigation data into a data format suitable for writing and transmission, and outputs the converted data to a memory board 65 (storage device). This memory board 65 includes a memory 61 as a storage element and a substrate 64 on which the memory 64 is mounted.

The memory 61 can store the navigation data of a predetermined time length (for example, 13 hours), and data before the predetermined time length is updated with the latest data as needed. When it is determined that a marine accident or the like has occurred, the update is stopped and the memory 61 continues holding the navigation data immediately before the marine accident. Note that, the memory 61 is protected so as to withstand a fire and water (submerging) caused by a marine accident, therefore the navigation data can be collected and the analysis can be performed even after the accident.

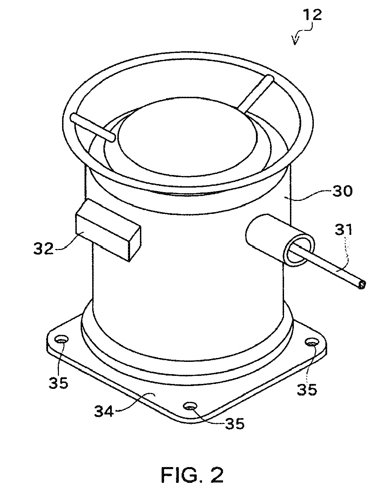

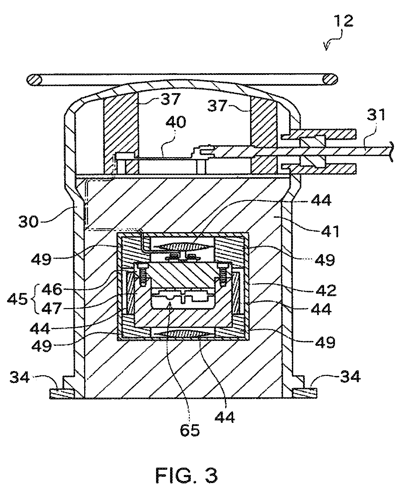

Next, a configuration of the data recording module 12 is described in detail with reference to Figs. 2 and 3. Fig. 2 is an external perspective view of the data recording module 12. Fig. 3 is a front cross-sectional view schematically showing a configuration inside of the data recording module 12.

As shown in Fig. 2, the data recording module 12 is constructed with a base 34, a beacon 32, and an outer capsule 30.

The base 34 is to fix the outer capsule 30 to the ship and is connected to a lower part of the outer capsule 30. The base 34 is formed in a rectangular shape and attaching holes 35 for fixing the base 34 to the ship using suitable attachments are formed therein.

The beacon 32 is attached to a side face part of the outer capsule 30 and can emit acoustic waves. When the data recording module 12 is missing after the marine accident, it can be found by the acoustic waves.

The outer capsule 30 is equipped with the main components of the data recording module 12 inside thereof, and this is particularly for protecting the memory 61. The outer capsule 30 is formed substantially in a cylinder shape, and a round-shaped cable 31 for receiving the navigation data from the data collecting module 11 is attached to the side face of the capsule 30. The data recording module 12 receives, via the round-shaped cable 31 connected to the outer capsule 30, the navigation data transmitted from the data collecting module 11.

As shown in Fig. 3, the round-shaped cable 31 is connected to the data converting device 40. The data converting device 40 is arranged in an upper part of the inside of the outer capsule 30. The data converting device 40 converts the navigation data into the suitable format. Moreover, near the data converting device 40, two or more external cooling packs 37 (cooling parts) for preventing a temperature increase by an operation heat of the apparatus, solar heat and the like are arranged along a wall face of the outer capsule 30.

Each external cooling pack 37 is formed in a cuboid shape and filled with a cooling material having a cooling effect (cooling medium or coolant). This cooling material is solid at a room temperature and liquefies or vaporizes (sublimate) by an increase of the surrounding temperature. When this phase transition (phase change) occurs, by absorbing a latent heat from the surroundings (i.e., the data converting device 40), the increase of the surrounding temperature is suppressed. Note that, the shape of external cooling pack 37 is not limited to the cuboid shape but may be a bag shape, for example.

The data converted by the data converting device 40 is outputted via the suitable cable to a central part of the outer capsule 30.

The central part of the outer capsule 30 is constructed with a heat insulating material 41, a holding capsule 42 (holding part), fixing rubbers 49, internal cooling packs 44 (cooling parts), and an inner capsule 45 (containing part), in this order from the outer side.

The heat insulating material 41 (heat insulating part) is formed in a cylindrical shape so as to surround the outside of the holding capsule 42. This heat insulating material 41 is made of a substance of a fine porous structure and protects the inside of heat insulating material 41 from heat by a fire, sunlight and the like.

Note that, as the heat insulating material 41, alternatively, a heat insulating material having a structure for limiting the motion of air molecules may be used, that is constituted by a foamed heat insulating material, such as urethane, or fine fumed silica and a substance which does not transmit an infrared ray. Further, the heat insulation may also be achieved by making the surface side of the heat insulating material 41 a mirror surface to prevent a transmission of radiant heat and making the wall face thereof have a two-layer structure of an outer layer and inner layer to form a vacuum space therebetween.

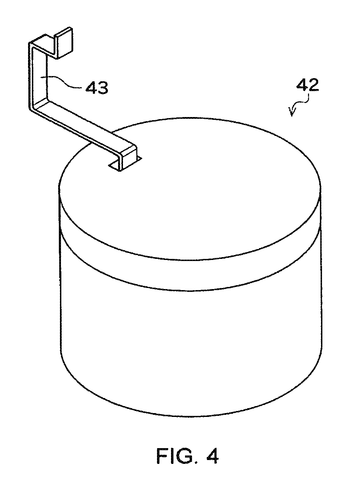

The holding capsule 42 is arranged inside the heat insulating material 41. The holding capsule 42 is made of metal and formed in a hollow cylindrical shape as shown in Fig. 4. Fig. 4 is an external perspective view showing the shape of the holding capsule. A flat cable 43 connects, through a cuboid-shaped hole formed in a top surface of the holding capsule 42, the inside and outside of the holding capsule 42. An outer end part of the flat cable 43 is connected to the data converting device 40 and the navigation data is transmitted with the data converting device 40.

The fixing rubbers 49 and the internal cooling packs 44 are arranged inside the holding capsule 42. The fixing rubber 49 fixes the inner capsule 45 so that it floats and does not contact with the holding capsule 42. The fixing rubber 49 has heat insulating properties and, thereby, the heat in the holding capsule 42 is hard to be transmitted to the inner capsule 45.

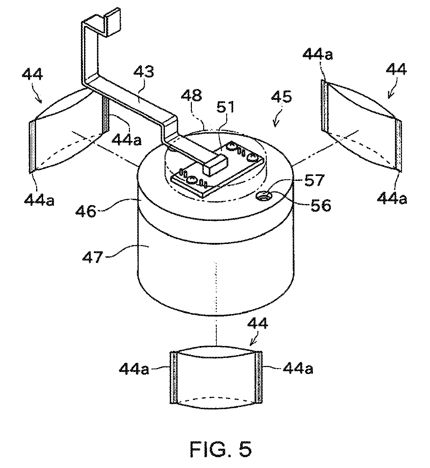

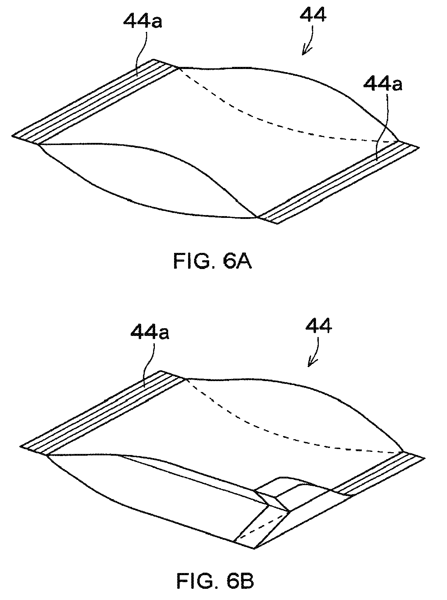

Next, the internal cooling packs 44 are described with reference to Figs. 5 and 6. Fig. 5 is an external perspective view showing the internal cooling packs 44 and the inner capsule 45. Figs. 6A and 6B are perspective views showing the internal cooling pack of before and after a joined part 44a is exfoliated. Fig. 6A shows the internal cooling pack 44 before the joined part 44a is exfoliated, and Fig. 6B shows the internal cooling pack 44 after the joined part 44a is exfoliated.

In this embodiment, as shown in Fig. 5, in addition to the internal cooling packs 44 arranged at three places so as to surround the side face of the inner capsule 45, two more internal cooling packs 44 are arranged on the top surface and the bottom surface of the inner capsule 45 (though not illustrated in Fig. 5). Note that the number and arrangement of the internal cooling packs 44 may be arbitrarily decided and the capacity of each inner cooing pack 44 may be set accordingly. The number, arrangement, and capacity of the internal cooling pack 44 are determined by a predetermined heat calculation based on specifications required for the navigation data recording apparatus (specifications such as how many hours the packs 44 and/or the capsule 45 can sustain at a certain temperature).

Water is filled in each internal cooling pack 44 as the cooling material (cooling medium or coolant). The internal cooling pack 44 is formed in the bag shape with a sheet material being joined at predetermined two parts (joined parts 44a).

The sheet material is constructed by a thin-film metal (for example, aluminum) interposing between two resin sheets (for example, chloroethylene). The sheet material contains the metal to prevent the water in the internal cooling pack 44 from leaking by vaporization. Further, the surfaces of the metal are covered by the resins to prevent corrosion of the metal, thereby the durability of the sheet material is increased.

When the temperature around the internal cooling pack 44 exceeds a predetermined value, because the water in the internal cooling pack 44 vaporizes and the pressure therein increases, one or both of the joined parts 44a is exfoliated to open (Fig. 6B). Note that, the temperature when the joined part 44a starts to be exfoliated may be adjusted by the water volume in the internal cooling pack 44 and the configuration of the joined parts 44a (increasing the joined areas of the joined parts 44a, etc.).

If a fire or the like occurs in the ship, the heat caused by the fire or the like is transmitted into the data recording module 12 and the temperature around the internal cooling pack 44 increases. Then, when the temperature exceeds the predetermined value, the joined part(s) 44a is/are exfoliated and the water outflows around the inner capsule 45. At this time, the water temperature has reached around 100°C and the temperature around the inner capsule 45 has exceeded the water temperature. Therefore, the water continuously vaporizes. In order to vaporize the water, vaporization heat (latent heat) is needed. The water absorbs the vaporization heat, therefore, the inner capsule 45 is cooled.

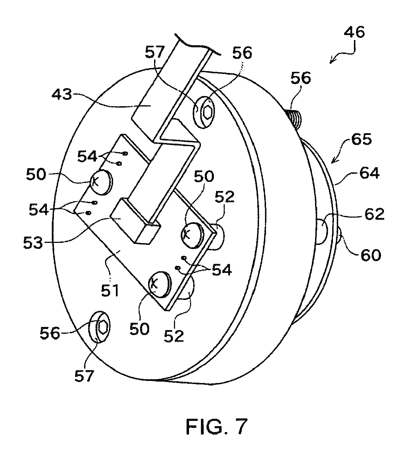

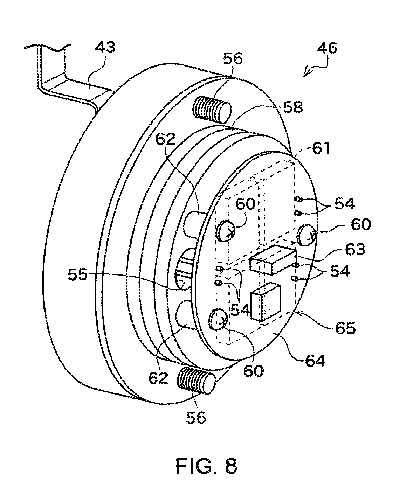

Next, the inner capsule 45 is described with reference to Figs. 5, 7, and 8. Fig. 7 is a perspective view showing the top side configuration of a lid part 46 of the inner capsule 45, and Fig. 8 is a perspective view showing the bottom side configuration of the lid part 46 of the inner capsule 45.

As shown in Fig. 5, the inner capsule 45 is formed externally in a cylinder shape. The inner capsule 45 is made of a thick metal material, and includes the lid part 46 illustrated in the upper part of Fig. 5 and a body part 47 illustrated in the lower part of Fig. 5. The lid part 46 and the body part 47 are fixed to each other by screws 56 being threadedly engaged with threaded holes 57 formed in the lid part 46.

As shown in Figs. 5 and 7, the lid part 46 includes a connector device 51. The connector device 51 is connected to the top side of the lid part 46 by top-side screws 50 via top-side spacers 52 made of a resin. Further, as shown in Fig. 5, the connector device 51 and its neighborhood is covered by a solidified epoxy resin for water and moisture prevention. The connector device 51 includes a data transmission terminal 53 for connecting the flat cable 43 to receive the navigation data.

Further, the connector device 51 is provided with a plurality of pairs of lead wires 54. As shown in Fig. 8, each pair of lead wires 54 are connected to the substrate 64 on the bottom side of the lid part 46 through a penetrating hole 55. In this embodiment, three penetrating holes 55 are formed in the lid part 46 and, thus, the total of three pairs of lead wires 54 are provided (though only one penetrating hole is illustrated in the figure). Thus, by arranging each pair of lead wires 54 directly through the corresponding penetrating hole 55, the lengths of the lead wires 54 can easily be unified to have the same impedance. However, only one penetrating hole 55 may be formed and some or all the pairs of lead wires 54 may be arranged therethrough. In this case, the lengths of the lead wires 54 may not be unified unless some excessive length of the wires are located between the substrate 64 and the bottom side of the lid part 46. Alternatively, although the lead wires 54 are considered to be pairs in this embodiment, the penetrating hole 55 may be formed for each single lead wire 54 to shorten the wire length to the maximum extent.

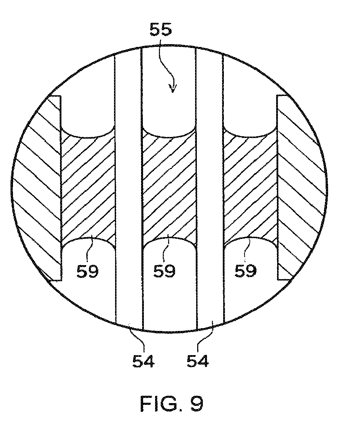

Further, as shown in Fig. 9, each penetrating hole 55 is sealed with glass 59 in a manner in which the pair of lead wires 54 for electrically connecting the connector device 51 and the substrate 64 (memory board 65) are held inside the penetrating hole 55. Fig. 9 is a cross-sectional view showing how the pair of lead wires 54 is sealed in the penetrating hole 55 with the glass 59.

As the method for sealing, the following method may also be used. That is, firstly, ground glasses are press-molded and solidified to form a ground glass in a hollow cylindrical shape. Next, the formed ground glass is inserted into the penetrating hole 55. Then, by heating the ground glass to about 1000°C, the ground glass is melted to seal the penetrating hole 55. Thus, by attaching the lead wires as described above, the memory 61 can be prevented from the water entering therein.

The connector device 51 and the substrate 64 are connected by being soldered to the ends of the lead wires 54, respectively. Thereby, the navigation data can be transmitted toward the memory 61. Similar to the connector device 51, the substrate 64 is attached, via bottom-side spacers 62 made of a resin, to the bottom side of the lid part 46 using bottom-side screws 60.

Further, the substrate 64 includes a data retrieving terminal 63. By connecting a predetermined standard cable or the like to the terminal, the navigation data stored in the memory 61 which is mounted on the substrate 64 can be read and acquired. Note that, an O-ring 58 is arranged on the bottom side of the lid part 46 to make it hard for the water to enter from a gap between the lid part 46 and the body part 47.

Thus, in the outer capsule 30, the heat resistant structure using the heat insulating material 41, the cooling structure using the cooling packs, and the pressure resistant structure using the inner capsule 45 are achieved. Therefore, the memory 61 can be protected from the influences of the marine accident.

As described above, the data recording module 12 of this embodiment includes the inner capsule 45, the internal cooling packs 44, and the heat insulating material 41. The internal cooling packs 44 are arranged outside of the inner capsule 45 and cool the inner capsule 45 by the heat absorbing action at the time of water vaporization. The heat insulating material 41 is arranged outside of the internal cooling packs 44.

Thereby, if the temperature inside of the heat insulating material 41 is increased by a fire caused from a marine accident or the like, the phase transition occurs to the water in the internal cooling pack 44. Because the temperature when the phase transition occurs is uniquely determined, the cooling can always be started at a fixed temperature without any variation. Therefore, the cooling of the inner capsule 45 can be started at a desired timing to prevent the temperature increase of the memory board 65 (semiconductor memory 61).

Further, the data recording module 12 of this embodiment is arranged outside of the internal cooling packs 44 and includes the holding capsule 42 for holding the internal cooling packs 44 near the inner capsule 45.

Thereby, because the internal cooling packs 44 can be held near the inner capsule 45, the components contained in the inner capsule 45 can be cooled efficiently.

Further, the data recording module 12 of this embodiment includes the internal cooling packs 44 arranged inside of the heat insulating material 41 and the external cooling packs 37 arranged outside of the heat insulating material 41.

Thereby, because the data recording module 12 further includes the internal cooling packs 44, the memory board 65 in the inner capsule 45 can be protected from the heat of fire. In addition, since the data recording module 12 further includes the external cooling packs 37, the temperature increase in the data recording module 12 caused by the solar heat and the like can be suppressed. Further, the external cooling packs 37 are arranged near the data converting device 40, the temperature increase by the operation heat of the data converting device 40 can be suppressed.

Further, in the data recording module 12 of this embodiment, each internal cooling pack 44 is a bag-shaped container filled with water and has the joined parts 44a each formed by closing the opening of the container.

Thereby, because the internal cooling pack 44 filled with water can be easily deformed, it can be arranged flexibly corresponding to the shape or the like of the inner capsule 45.

Further, in the data recording module 12 of this embodiment, when the temperature near the internal cooling pack 44 exceeds the predetermined value, the joined part(s) 44a is/are exfoliated.

Thereby, the cooling is not performed when the temperature near the internal cooling pack 44 is below the predetermined value. On the other hand, when the temperature near the internal cooling pack 44 exceeds the predetermined value, because the water outflows, thereby the cooling can start at once.

Further, in the data recording module 12 of this embodiment, at least a part of the internal cooling pack 44 is made of metal.

Thereby, because the internal cooling pack 44 becomes structurally strong, a water leak from a breakage of the internal cooling pack 44 can be prevented. Moreover, because a gas permeability of the internal cooling pack 44 can be suppressed, it can be prevented that water vapor leaks out of the internal cooling pack 44.

Further, the data recording module 12 of this embodiment also includes the memory board 65 for storing the navigation data. The memory board 65 is contained in the inner capsule 45.

That is, since the data recording module 12 further includes the memory board 65 that is sensitive to heat, it needs to be suitably detected that an accident such as a fire has occurred so that the cooling immediately starts. Therefore, it is especially preferred to apply the method of this embodiment.

Further, in the data recording module 12 of this embodiment, the inner capsule 45 includes the body part 47 and the lid part 46. The body part 47 has the containing space. The lid part 46 covers the opening of the body part 47. The lead wires 54 for transmitting to the memory board 65 the navigation data which is inputted from outside are connected to the memory board 65 through the penetrating holes 55 formed in the lid part 46 in the thickness direction, and the lead wires 54 are sealed with the glass 59 in the penetrating holes 55.

Thereby, the memory 61 can be made into the pressure resistant structure. Further, because the pressure resistant structure with high reliability can be achieved with one-time sealing operation, the fabricating efficiency can be improved.

Further, in the data recording module 12 of this embodiment, a plurality of lead wires are arranged. The memory board 65 is arranged near the lid part 46 and the ends of the lead wires are connected to the memory board 65.

Thereby, because the lengths of the lead wires are easily unified, impedance matching is achieved and the quality degradation of the data to be transmitted can be prevented.

Further, the data recording module 12 of this embodiment further includes the data converting device 40 for converting the navigation data which is inputted from outside. The data converting device 40 is arranged outside of the heat insulating material 41.

Thereby, the heat generated by the operation of the data converting device 40 can be prevented from being transmitted to the inside of the heat insulating material 41. Therefore, the operation heat of the data converting device 40 is prevented from affecting the memory board 65.

Further, the navigation data recording apparatus 10 of this embodiment includes the data recording module 12 and the data collecting module 11. The data collecting module 11 receives the navigation data from the ship instrument 13 and transmits it to the data recording module 12.

Thereby, the navigation data recording apparatus 10 that can robustly protect the navigation data can be provided.

One embodiment of the present invention is described above; however, the configuration of the embodiment may also be modified as follows, for example.

The holding capsule 42 may be formed in any shape and may be made of any material, without limited to the hollow cylindrical shape. For example, it can be formed in a cuboid or a sphere.

The cooling material sealed in the external cooling pack 37 and the internal cooling pack 44 may be in any one of solid state, liquid state, and gel state, and various kinds of material may be used to the contents therein. Moreover, by changing the contents, the temperature to start the cooling may be adjusted by the properties of the contents.

In the internal cooling pack 44, the joined parts 44a are formed in two places, however, the number of the joined parts 44a and the positions for the joined parts 44a to be formed are not limited to this. The joined part may be formed in at least one place. For example, the entire edge of the internal cooling pack 44 may be formed as the joined part.

In this embodiment, the internal cooling pack 44 opens and the water therein outflows when the water exceeds the boiling temperature, however, it may be configured so that the internal cooling pack 44 has a two-layer structure to prevent the water from outflowing.

The inner capsule 45 may be formed in any shape and may be made of any material, and the external shape is not limited to the cylinder shape. For example, it may be a cuboid or sphere, and if the structure which can sustain for required specifications is used, the shape and the material will not be limited.

In this embodiment, the example in which the container is applied to the data recording module is described, however, other than this, the container may be applied to a heat-resistant safe and the like.

In the foregoing specification, specific embodiments of the present invention have been described. However, one of ordinary skill in the technique appreciates that various modifications and changes can be performed without departing from the scope of the present invention as set forth in the claims below. Accordingly, the specification and figures are to be regarded in an illustrative rather than a restrictive sense, and all such modifications are intended to be included within the scope of present invention. The benefits, advantages, solutions to problems, and any element(s) that may cause any benefit, advantage, or solution to occur or become more pronounced are not to be construed as a critical, required, or essential features or elements of any or all the claims. The invention is defined solely by the appended claims including any amendments made during the pendency of this application and all equivalents of those claims as issued.

Moreover in this document, relational terms such as first and second, top and bottom, and the like may be used solely to distinguish one entity or action from another entity or action without necessarily requiring or implying any actual such relationship or order between such entities or actions. The terms "comprises," "comprising," "has," "having," "includes," "including," "contains," "containing" or any other variation thereof, are intended to cover a non-exclusive inclusion, such that a process, method, article, or apparatus that comprises, has, includes, contains a list of elements does not include only those elements but may include other elements not expressly listed or inherent to such process, method, article, or apparatus. An element proceeded by "comprises...a," "has...a," "includes...a," "contains...a" does not, without more constraints, preclude the existence of additional identical elements in the process, method, article, or apparatus that comprises, has, includes, contains the element. The terms "a" and "an" are defined as one or more unless explicitly stated otherwise herein. The terms "substantially," "essentially," "approximately," "about" or any other version thereof, are defined as being close to as understood by one of ordinary skill in the technique, and in one non-limiting embodiment the term is defined to be within 10%, in another embodiment within 5%, in another embodiment within 1% and in another embodiment within 0.5%. The term "coupled" as used herein is defined as connected, although not necessarily directly and not necessarily mechanically. A device or structure that is "configured" in a certain way is configured in at least that way, but may also be configured in ways that are not listed.

## Claims

1. A container, comprising:
a containing part;
a cooling part arranged outside of the containing part and for cooling by a heat absorbing action at the time of a phase transition; and
a heat insulating part arranged outside of the cooling part.

2. The container of Claim 1, further comprising a holding part arranged outside of the cooling part and for holding the cooling part near the containing part.

3. The container of Claim 1 or 2, wherein another cooling part is arranged outside of the heat insulating part, in addition to the inside of the heat insulating part.

4. The container of any one of Claims 1 to 3, wherein the cooling part is a bag shaped container filled with a cooling material and has a joined part formed by closing an opening of the container.

5. The container of Claim 4, wherein the joined part is configured to be exfoliated when a temperature near the cooling part reaches a predetermined temperature or more.

6. The container of Claim 4 or 5, wherein at least a part of the cooling part is made of metal.

7. A navigation data recording module, comprising;
the container of any one of Claims 1 to 6; and
a storage device for storing navigation data, the storage device being contained in the containing part.

8. The navigation data recording module of Claim 7, wherein the containing part includes:
a body part having a containing space; and
a lid part covering an opening of the body part;
wherein a lead wire for transmitting to the storage device the navigation data inputted from outside is connected to the storage device through a penetrating hole formed in the lid part in the thickness direction, and the lead wire is sealed in the penetrating hole with glass.

9. The navigation data recording module of Claim 8, wherein the lead wire includes a plurality of lead wires, the storage device is arranged near the lid part, and the ends of the lead wires are connected to the storage device.

10. The navigation data recording module of any one of Claims 7 to 9, further comprising a data converting device for converting the navigation data inputted from outside, the data converting device being arranged outside of the heat insulating part.

11. A navigation data recording apparatus, comprising;
the navigation data recording module of any one of Claims 7 to 10; and
a navigation data collecting module for receiving navigation data from a ship instrument and transmitting it to the navigation data recording module.
